Europäisches Patentamt

European Patent Office

Office européen des brevets

(11) Veröffentlichungsnummer: **0 420 361 A1**

# EUROPÄISCHE PATENTANMELDUNG

(21) Anmeldenummer: 90250196.4

(22) Anmeldetag: 01.08.90

(51) Int. Cl.5: **H01R 29/00, H05K 1/02, H05K 1/00**

(30) Priorität: 27.09.89 DE 8911685 U

(43) Veröffentlichungstag der Anmeldung:
03.04.91 Patentblatt 91/14

(84) Benannte Vertragsstaaten:
AT BE CH DE FR GB IT LI NL

(71) Anmelder: MANNESMANN Aktiengesellschaft
Mannesmannufer 2
W-4000 Düsseldorf 1(DE)

(72) Erfinder: Buschmann, Ulrich, Dipl.-Ing.
Ahornweg 10

W-7915 Elchingen 3(DE)
Erfinder: Gomoll, Günter, Dipl.-Ing.
Mörikeweg 10
W-7916 Nersingen/Leibi(DE)
Erfinder: Hauslaib, Wolfgang, Dipl.-Ing.
Achstrasse 65
W-7907 Langenau(DE)

(74) Vertreter: Presting, Hans-Joachim, Dipl.-Ing.
et al
Meissner & Meissner Patentanwaltsbüro
Herbertstrasse 22
W-1000 Berlin 33(DE)

(54) **Leiterplatte für elektronische bzw. elektromechanische Geräte.**

(57) Die Erfindung betrifft eine Leiterplatte für elektronische bzw. elektromechanische Geräte mit einem mechanisch betätigbaren Umschalter für mindestens zwei unterschiedliche Netzspannungen des Geräte-Energieversorgungsteils.

Um bisher relativ aufwendige Spannungswahlschalter zu vereinfachen und wirtschaftlich herstellen zu können, wird erfindungsgemäß vorgeschlagen, daß in der Leiterplatte ein polygonaler Ausschnitt (2) vorgesehen ist, dessen Rand (3) gerade Polygonseiten (2a; 2b) bildet, daß jeder Polygonseite (2a; 2b) eine Kontaktfläche zugeordnet ist, die jeweils mit einem elektrischen Leiter (5) des Geräte-Energieversorgungsteils verbunden ist, wobei zwei sich gegenüberliegenden Kontaktflächen (4) einem Spannungspotential angehören und daß in den Ausschnitt (2) eine Kontaktfeder (6) einführbar ist, die jeweils den Kontaktflächen (4) zugeordnet und diese kontaktierende Federschenkel (6a, 6b) aufweist.

Fig.2

EP 0 420 361 A1

## LEITERPLATTE FÜR ELEKTRONISCHE BZW. ELEKTROMECHANISCHE GERÄTE

Die Erfindung betrifft eine Leiterplatte für elektronische bzw. elektromechanische Geräte mit einem mechanisch betätigbaren Umschalter für zumindest zwei unterschiedliche Netzspannungen des Geräte-Energieversorgungsteils.

Für die Umschaltung von einer in einem Land vorliegenden Gerätespannung auf eine andere Spannung (wie z.B. 220 V auf 110 V) sind sog. Spannungswahlschalter üblich. Diese sind relativ aufwendig und in einem Gehäuse angeordnet und daher wenig wirtschaftlich herstellbar.

Der Erfindung liegt die Aufgabe zugrunde, die aufwendigen Spannungswahlschalter zu vereinfachen und eine wirtschaftliche Herstellung zu garantieren.

Die gestellte Aufgabe wird erfindungsgemäß dadurch gelöst, daß ein polygonaler Ausschnitt vorgesehen ist, dessen Rand gerade Polygonseiten bildet, daß jeder Polygonseite eine Kontaktfläche zugeordnet ist, die jeweils mit einem elektrischen Leiter des Geräte-Energieversorgungsteils verbunden ist, wobei zwei sich gegenüberliegende Kontaktflächen einem Spannungspotential angehören und daß in den Ausschnitt eine Kontaktfeder einführbar ist, die jeweils den Kontaktflächen zugeordnete und diese kontaktierende Federschenkel aufweist. Diese Lösung ist äußerst einfach, preiswert und vermeidet die Nachteile geschlossener Spannungsswahlschalter-Gehäuse. So kann eine Kontaktfeder für einige Pfennige hergestellt werden. Außerdem können nach dem Prinzip mehr als zwei Spannungsstufen erfaßt werden.

Eine Ausgestaltung der Erfindung besteht darin, daß die Federschenkel durch den Ausschnitt hindurchragen und die Kontaktflächen auf der einen Seite berühren und daß auf der anderen Seite die Federschenkel eine U-Form bilden. Diese Gestaltung der Kontaktfeder gewährleistet einen sicheren Halt in der Leiterplatte.

Eine weitere Verbesserung der Erfindung besteht darin, daß zwecks Arretierung der Kontaktfeder an deren Federschenkeln jeweils außenliegende Einschnitte angebracht sind, durch die Spreizarme gebildet sind, die sich im eingebauten Zustand der Kontaktfeder auf der den Kontaktflächen gegenüberliegenden Seite der Leiterplatte abstützen. Die Spreizarme erhöhen die Befestigungssicherheit der Kontaktfeder in der Leiterplatte noch weiter.

Ein Ausführungsbeispiel der Erfindung ist in der Zeichnung schematisch dargestellt und wird um folgenden näher erläutert. Es zeigen:

Fig. 1 einen Querschnitt durch die Leiterplatte mit Seitenansicht der Kontaktfeder,

Fig. 2 eine Draufsicht auf die Leiterplatte mit eingesetzter Kontaktfeder und

Fig. 3 eine Seitenansicht der Kontaktfeder vor dem Einsetzen.

Die Leiterplatte 1, deren diskrete bzw. integrierte Bauteile nicht näher gezeigt sind, weist einen polygonalen Ausschnitt 2 auf. Im Ausführungsbeispiel ist das Polygon quadratisch. Dementsprechend sind jeweils zwei sich gegenüberliegenden Polygonseiten 2a bzw. 2b vorhanden, die den Rand 3 des Polygons bilden. Jeder der Polygonseiten 2a, 2b sind Kontaktflächen 4 zugeordnet. Zu jeder Kontaktfläche 4 führt ein elektrischer Leiter 5 für den Energieversorgungsteil des Gerätes.

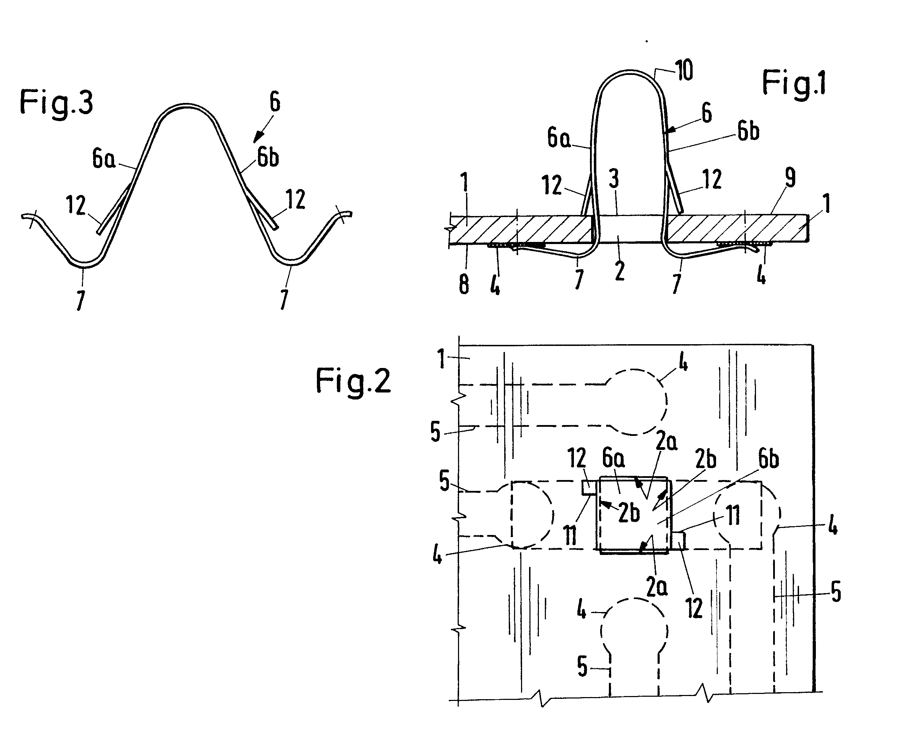

Zwei sich gegenüberliegende Kontaktflächen 4 gehören zu einem Leiterkreis eines einheitlichen Spannungspotentials, von z.B. 110 V oder 220 V. Die Verbindung der beiden Pole wird durch eine Kontaktfeder 6 geschlossen. Die Kontaktfeder 6 verbindet durch ihre Eigenschaft als metallischer Leiter die beiden sich gegenüberliegenden Kontaktflächen 4, wobei die Kontaktfläche 4 kontaktierende Federschenkel 6a, 6b aufweist. Der Strom fließt daher im gezeichneten Ausführungsbeispiel von der in Fig. 2 linken Kontaktfläche 4 über die Kontaktfeder 6 zu der in Fig. 2 rechten Kontaktfläche 4 und weiter in den Leiter 5.

Der sichere Sitz der Kontaktfeder 6 wird nicht nur durch die Schenkelform erreicht, sondern besonders durch den Verlauf in bezug auf den Ausschnitt 2. Die Federschenkel 6a, 6b ragen durch den Ausschnitt 2 der Leiterplatte 1 hindurch, die aus Kunststoff besteht, auf die wie gezeichnet untere Seite der Leiterplatte 1, wobei in diesem Fall die Federschenkel 6a, 6b über eine weitere Biegung 7 Federkraft auf die Kontaktflächen 4 übertragen. Währenddem wie gezeichnet die Federschenkel 6a, 6b auf den Kontaktflächen 4 der einen Seite 8 enden, sind auf der anderen Seite 9 die Federschenkel 6a, 6b einer U-Form 10 vereinigt.

Der Sitz der Kontaktfeder 6 ist jedoch noch weiter verbessert. An den Federschenkeln 6a, 6b sind jeweils in gegensinnige Richtungen weisende Einschnitte 11 angebracht. Dadurch lassen sich Spreizarme 12 herausbiegen, die sich im eingebauten Zustand der Kontaktfeder 6 auf der den Kontaktflächen 4 gegenüberliegenden Seite 9 der Leiterplatte krallenartig aufstützen. Hierbei kommt es zu einer gegenseitigen Verspannung der Spreizarme 12 und der Federschenkel 6a, 6b über die Biegung 7.

## Ansprüche

1. Leiterplatte für elektronische bzw. elektromechanische Geräte mit einem mechanisch betätigbaren Umschalter für zumindest zwei unterschiedliche Netzspannungen des Geräte-Energieversorgungsteils,
dadurch gekennzeichnet,
daß ein polygonaler Ausschnitt (2) vorgesehen ist, dessen Rand (3) gerade Polygonseiten (2a;2b) bildet, daß jeder Polygonseite (2a;2b) eine Kontaktfläche (4) zugeordnet ist, die jeweils mit einem elektrischen Leiter (5) des Geräte-Energieversorgungsteils verbunden ist, wobei zwei sich gegenüberliegende Kontaktflächen (4) einem Spannungspotential angehören und daß in den Ausschnitt (2) eine Kontaktfeder (6) einführbar ist, die jeweils den Kontaktflächen (4) zugeordnete und diese kontaktierende Federschenkel (6a,6b) aufweist.

2. Leiterplatte nach Anspruch 1,
dadurch gekennzeichnet,
daß die Federschenkel (6a,6b) durch den Ausschnitt (2) hindurchragen und die Kontaktflächen (4) auf der einen Seite (8) berühren und daß auf der anderen Seite (9) die Federschenkel (6a,6b) eine U-Form (10) bilden.

3. Leiterplatte nach den Ansprüchen 1 und 2,
dadurch gekennzeichnet,
daß zwecks Arretierung der Kontaktfeder (6) an deren Federschenkeln (6a,6b) jeweils außenliegende Einschnitte (11) angebracht sind, durch die Spreizarme (12) gebildet sind, die sich im eingebauten Zustand der Kontaktfeder (6) auf der den Kontaktflächen (4) gegenüberliegenden Seite (9) der Leiterplatte (1) abstützen.

Fig.1

Fig.2

Fig.3

**Europäisches Patentamt**

**EUROPÄISCHER RECHERCHENBERICHT**

Nummer der Anmeldung

EP    90 25 0196

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A | DE-A-3304045 (BRAUN AG) <br> * Seite 8, Zeile 17 – Seite 9, Zeile 24; Figuren 1-5 * <br> --- | 1 | H01R29/00 <br> H05K1/02 <br> H05K1/00 |
| A | FR-A-2506526 (DAV INDUSTRIES) <br> * Seite 2, Zeile 54 – Seite 3, Zeile 35; Figuren 1-6 * <br> --- | 1 | |
| A | FR-A-2618630 (NEIMAN) <br> * Seite 2, Zeilen 9 – 15; Figur 1 * <br> ----- | 1 | |
| | | | **RECHERCHIERTE SACHGEBIETE (Int. Cl.5 )** <br><br> H01R <br> H05K <br> H01H |

Der vorliegende Recherchenbericht wurde für alle Patentansprüche erstellt

| Recherchenort | Abschlußdatum der Recherche | Prüfer |
|---|---|---|
| BERLIN | 20 DEZEMBER 1990 | CLOSA, D |